# EUROPEAN PATENT APPLICATION

(11) **EP 2 360 713 A2**
(43) Date of publication of application: **24.08.2011**
(21) Application number: 10159457.0
(22) Date of filing: 09.04.2010
(51) Int. Cl.: H01J 37/32

(54) **Multi Inductively Coupled Plasma Reactor and Method Thereof**

(30) Priority: 22.02.2010 KR 20100015917; 22.02.2010 KR 20100015918
(71) Applicant: New Power Plasma Co., Ltd., Suwon-si, Gyeonggi-do 443-390 (KR)
(72) Inventor: Huh, No-Hyun, Gyeonggi-do (KR); Kim, Gyoo-Dong, 448-130, Gyeonggi-do (KR); Nam, Chang-Woo, 449-814, Gyeonggi-do (KR); Park, Sung-Min, Chungcheongnam-do (KR); Choi, Dae-Kyu, Gyeonggi-do (KR)
(74) Representative: Greene, Simon Kenneth

(57) **Abstract**

Disclosed is a multi-inductively coupled plasma reactor and method thereof. In a multi-inductively coupled plasma reacting method, an etching method to increase a specific portion of a substrate to be processed includes etching a specific portion of a substrate to be processed; and depositing a passivation layer on a surface of the specific portion etched, wherein the etching and depositing steps are repeatedly proceeded, and one of both steps is executed when there is plasma formed by a central plasma source (20) and a peripheral plasma source (30). According to the multi-inductively coupled plasma reactor and method thereof of the invention, it is possible that plasma is uniformly processed on the entire area of the substrate since the central plasma source and the peripheral source are provided separately. Further, it is possible to form an independent multiple plasma area without electrical interference in the plasma reactor using the interference prevention electrode (35) grounded between the central plasma source and the peripheral plasma source. Further, the plasma formed by the central plasma source and the peripheral plasma source is used to deeply etch a specific portion of the substrate to be processed.

## Description

### BACKGROUND OF THE INVENTION

### 1. Field of the Invention

The invention relates to a multi-inductively coupled plasma reactor and method thereof, and in particular to a method to deeply etch a specific portion of a substrate to be processed using a multi-inductively coupled plasma.

### 2. Description of the Prior Art

In the silicon anisotropic etching method, processes of etching a specific portion of substrate to be processed and depositing a passivation layer on the specific portion etched are repeatedly performed. The specific portion of the substrate to be processed is etched in a desired depth while the etching and depositing processes are repeatedly performed. Such etching and depositing processes are accomplished by plasma.

Plasma is highly ionized gas including the same number of positive ions and electrons. Plasma discharge is used to excite gas in order to generate activated gas including ions, free radicals, atoms and molecules. The activated gas is widely used, that is, in various semiconductor manufacturing processes, for example, etching, deposition, cleaning and ashing, to manufacture devices such as integrated circuit device, liquid crystal display, solar cell, etc.

There are various kinds of plasma sources to generate plasma, and capacitive coupled plasma and inductive coupled plasma that use radio frequency are representative examples. A capacitive coupled plasma source has a high faculty of a correct capacitive coupling control and ion control so that it has a merit of high process productivity compared with other plasma sources. However, when a capacitive coupling electrode becomes large scale in order to process large scale substrates to be processed, the electrode is deformed or damaged due to the deterioration of the electrode. In this case, the electric filed intensity becomes non-uniformed so that the plasma density may be non-uniformed and the interior of reactor may be contaminated. In also the case of the inductive coupled plasma source, it is not easy to obtain an uniform plasma density like the case of making the area of an inductive coil antenna large

Recently, the semiconductor manufacturing industry requires a more enhanced plasma process technology due to various factors such as ultra refinement of semiconductor device, large scaled substrate to be processed such as silicon wafer substrates, glass substrates or plastic substrates used to manufacture semiconductor circuits, and development of new substance to be processed. Particularly, a technology of enhanced plasma source and plasma process having a superior process performance with respect to a large scale substrate to be processed is required. Further, various semiconductor manufacturing apparatus using laser is provided. The semiconductor manufacturing process using laser is widely applied to various processes such as depositing, etching, annealing, cleaning with respect to the substrate to be processed. There also exist the problems described above in such semiconductor manufacturing processes using laser.

The large scale substrate to be processed entirely brings about large scale production equipment. The large scale production equipment increases entire equipment area, resulting in increase of production cost. Therefore, a plasma reactor and plasma process system requiring as small equipment area as possible is needed. Particularly, productivity per unit area acts as an important factor that affects the price of a final product in the semiconductor manufacturing process.

Further, due to the large scale substrate to be processed, there occurs a problem that central area and peripheral area of the substrate to be processed are not processed uniformly by plasma. That is, since plasma forms centered on the central area of the substrate to be processed compared with the peripheral area, there occurs a difficulty that the substrate to be processed is processed entirely and uniformly.

### SUMMARY OF THE INVENTION

Accordingly, it is an object of this invention to provide a multi-inductively coupled plasma reactor and method thereof, capable of enhancing process efficiency with respect to a large scale substrate to be processed by forming uniform plasma on the large area using a central plasma source and a peripheral source.

It is an another object of this invention to provide a multiple gas supplier and a plasma reactor, capable of enhancing process efficiency with respect to a large scale substrate to be processed by forming uniform plasma on the large area using process gas provided multiply and central plasma source and peripheral plasma source.

According to a first aspect of the present invention, in a multi-inductively coupled plasma reacting method, an etching method to increase a specific portion of a substrate to be processed includes etching a specific portion of a substrate to be processed; and depositing a passivation layer on a surface of the specific portion etched, wherein the etching and depositing steps are repeatedly proceeded, and one of both steps is executed when there is plasma formed by a central plasma source and a peripheral plasma source.

Preferably, both steps of etching and depositing may be executed when there is plasma formed by the central plasma source and the peripheral plasma source.

Preferably, the passivation layer of the specific portion may be removed and etched again when there is plasma formed by the central plasma source and the peripheral plasma source.

Preferably, the central plasma source and the peripheral plasma source each generate plasma using an inductive coupling method.

Preferably, the central plasma source generates plasma using a capacitive coupling method and the peripheral plasma source generates plasma using an inductive coupling method.

According to a first aspect of the present invention, a multi-inductively coupled plasma reactor includes an reactor body that internally includes a substrate support to support a substrate to be processed; a central plasma source that generates plasma in a central area of the reactor body; and a peripheral plasma source that generates plasma in a peripheral area of the reactor body, wherein an etching and a deposition of a passivation layer with respect to a specific portion of the substrate to be processed are repeatedly performed.

Preferably, the central plasma source and the peripheral plasma source each may generate plasma using an inductive coupling method.

Preferably, the central plasma source may generate plasma using a capacitive coupling method and the peripheral plasma source generates plasma using an inductive coupling method.

Preferably, the central plasma source and the peripheral plasma source may be arranged differently from the substrate to be processed in their heights.

Preferably, the central plasma source may be one of a planar form and a dome form.

Preferably, the multi-inductively coupled plasma reactor may further include a central power supply to provide the central plasma source with power and a peripheral power supply to provide the peripheral plasma source with power.

Preferably, the central power supply and the peripheral power supply may provide power source of different frequencies, respectively.

Preferably, he central power supply source may provide power having frequency of 1∼5MHz, and the peripheral power supply source having frequency of 1∼500KHz.

Preferably, the substrate support may be connected to a bias supply source that provides a bias power source of 1∼50MHz.

Preferably, the central plasma source or the peripheral plasma source may include a radio frequency antenna; and a magnetic core cover that covers the radio frequency antenna and is arranged such that an entrance of magnetic flux is directed to an interior of the reactor body.

Preferably, the radio frequency antenna may further include a paraday shield in its lower portion.

Preferably, an interference prevention electrode may be arranged between the central plasma source and the peripheral plasma source and grounded so as to electrically separate the central plasma source and the peripheral plasma source each other.

Preferably, the central plasma source may include a central gas supplier and the peripheral plasma source includes a peripheral gas supplier, such that a process gas is supplied.

Preferably, the central gas supplier and the peripheral gas supplier may include a plurality of gas nozzles.

Preferably, the central gas supplier and the peripheral gas supplier may provide the same process gas or different process gas from the gas supply source.

In accordance with the multi-inductively coupled plasma reactor and method thereof according to the invention, it is possible that plasma is uniformly processed on the entire area of the substrate since the central plasma source and the peripheral source are provided separately.

Further, it is possible to form an independent multiple plasma area without electrical interference in the plasma reactor using the interference prevention electrode grounded between the central plasma source and the peripheral plasma source.

Further, the plasma formed by the central plasma source and the peripheral plasma source is used to deeply etch a specific portion of the substrate to be processed.

### BRIEF DESCRIPTION OF THE DRAWINGS

To fully understand the invention, a preferred embodiment of the invention will be described with reference to the accompanying drawings. The embodiment of the invention may be varied in various formats, and the scope of the invention should not be restricted to the embodiment described below in detail. The embodiment is provided to fully describe the invention to a skilled person in this field. Accordingly, shapes or the like in the drawings may be exaggerated to provide more precise description. This invention will be described in detail with reference to the attached drawings in which like numerals refer to like elements. Known functions and constructions that are regarded to make the gist of the invention obscured will be omitted.
FIG.1 is a sectional view showing a plasma process apparatus in which a central plasma source and a peripheral plasma source are separated each other according to a preferred embodiment of the invention;
FIG.2 is an upper sectional view showing a plasma process apparatus that has no step between a central plasma source and a peripheral plasma source and has a gas inlet formed in the plasma source;
FIG.3 is an upper sectional view showing a plasma process apparatus that has a step between a central plasma source and a peripheral plasma source and has a gas inlet formed on a side wall of a reactor body;
FIG.4 is an upper sectional view showing a plasma process apparatus having an interference prevention electrode that is grounded between a central plasma source and a peripheral plasma source;
FIG.5 is an upper sectional view showing a plasma process apparatus that has a central plasma source formed of a planar shape;
FIG.6 is an upper sectional view showing a plasma process apparatus that has a central plasma source formed of a dome shape;
FIG.7 is an upper sectional view showing a plasma process apparatus that has a Faraday shield;
FIG.8 is a plane view showing the Faraday shield shown in FIG.7;
FIG.9 is a sectional view showing a plasma process apparatus that an double central power supply and a double peripheral power supply and a double bias power supply;
FIG.10 is a sectional view showing a plasma process apparatus that has a central plasma source formed of capacitive coupled plasma;
FIG.11 is a sectional view showing a plasma process apparatus that has a multiple gas supply structure according to a preferred embodiment of the invention;
FIG.12 is a plane view showing a dielectric window having a plurality of gas supply holes that are installed in a plasma process apparatus of the invention; and
FIG.13 is a sectional view showing a plasma process apparatus in which a central gas supplier and a peripheral gas supplier are provided with different process gases, respectively, according to a preferred embodiment of the invention

### DETAILED DESCRIPTION OF THE PREFERRED EMBODIMENT

To fully understand many objects to be accomplished by various embodiments and operational advantages of this invention, preferred embodiments of this invention will be described in a more detailed manner with reference to the attached drawings. In the attached drawings, like elements will be referred to as like numerals. Furthermore, the detailed technical explanation of already known functions and constructions will be omitted herein to avoid a faint determination of the subject matter of this invention.

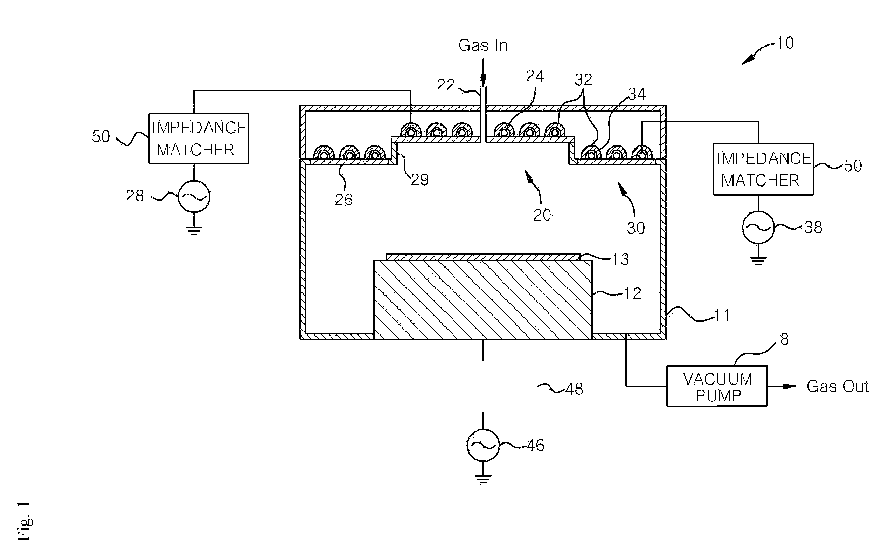

FIG.1 is a sectional view showing a plasma process apparatus in which a central plasma source and a peripheral plasma source are separated each other according to a preferred embodiment of the invention.

Referring to FIG. 1, a multi-inductively coupled plasma reactor 10 according to a preferred embodiment of the invention is constructed of a reactor body 11, a central plasma source 20 and a peripheral plasma source 30. The reactor body 11 internally has a substrate support 12 having a substrate 13 to be processed thereon, and is connected to a vacuum pump 8 in its bottom. The central plasma source 20 is included in an upper portion of the reactor body 11 to form plasma into a central area in the reactor body 11. The peripheral plasma source 30 forms plasma into a peripheral area in the reactor body 11.

The reactor body 11 may be manufactured by a metal material such as aluminum, stainless steel and copper. Further, it may be manufactured by a coated metal such as anode processed aluminum or nickel plated aluminum. Further, it may be used by mixed metals in which carbon nano tubes are covalent bonded. Further, it may be manufactured by refractory metals. As another alternative, it may be possible to manufacture all or a part of the reactor body 11 with an electrical dielectric material such as quartz and ceramic. As such, the reactor body 11 may be manufactured by any material that is suitable to perform an intended plasma process. The reactor body 11 may have a structure that is suitable to the substrate 13 to be processed and meets condition to uniformly generate plasma, for example, circular structure, rectangular structure, etc. The substrate 13 to be processed may be a wafer substrate, a glass substrate or a plastic substrate to manufacture various devices such as a semiconductor device, a display device and a solar cell.

The plasma reactor 10 internally includes a substrate support 12 to support the substrate 13 to be processed. The substrate support 12 is connected to a bias power supply 46 (two bias power supplies to provide different radio frequency power sources may be connected) and biased. A bias power supply is electrically connected to the substrate support 12 through an impedance matcher 48 (or respective impedance matchers). Further, the substrate support 12 may be differently embodied as a structure having a zero potential without providing bias power source. According to an embodiment of the invention, it is preferable to provide bias power source of 1∼50MHz from the power supply 46 and to provide the substrate support with bias power source of 13.56MHz.

Further, the substrate support 12 may include an electrostatic chuck. Further, the substrate support 12 may include a heater. Basically, the substrate support 12 may be constructed as a fixed type or a vertical elevation type. Further, the substrate support 12 has a structure in that it can linearly or circularly move in parallel to an electrode assembly. Such a movable structure may include a driving mechanism to linearly or circularly move the substrate support 12. A gas discharging baffle (not shown) may be constructed in the lower portion of the reactor body 11 in order to uniformly discharge the gases.

The central plasma source 20 and the peripheral plasma source 30 are formed with different heights each other with respect to the substrate 12 to be processed. That is, the central plasma source 20 is formed highly in the substrate 13 to be processed compared with the peripheral plasma source 30, so plasma is prevented from being concentrated on the center area. Therefore, plasma can be uniformly formed and process efficiency with respect to the substrate to be processed can be enhanced. By doing so, plasma can be uniformly processed in the entire area of the substrate in consideration of intensity and strength of central plasma and peripheral plasma. Further, an insulation section 29 for electrical shield can be provided between the central plasma source 20 and the peripheral plasma source 30.

The central plasma source 20 may be connected to a gas inlet 22 to be provided with process gas from a gas supply source (not shown). At this time, the gas inlet 22 may be included for the central plasma source 20 only and may be included for both of the central plasma source 20 and the peripheral plasma source 30.

The central plasma source 20 and the peripheral plasma source 30 may include radio frequency antennas 24, 34 and a dielectric window 26, respectively. The radio frequency antennas 24, 34 provided in the central plasma source 20 and the peripheral plasma source 30, respectively are connected to the central power supply 28 and the peripheral power supply 38 and provided with radio frequency that is impedance processed through the impedance matcher 50. At this time, the central power supply 28 and the peripheral power supply 38 can provide the same frequency or different frequencies. The power supply of the invention provides radio low frequency, wherein it provides frequency of 1∼5MHz in the central power supply 28 and frequency of 1∼500KHz in the peripheral power supply. Preferably, it provides frequency of 2MHz in the central power supply 28 and frequency of 400MHz in the peripheral power supply 38.

The dielectric window 26 is included in a lower portion of the radio frequency antenna so that magnetic flux generated in the radio frequency antennas 24 and 34 passes therethrough. At this time, a magnetic core cover 32 is installed on the radio frequency antennas 24 and 34 in order that the flux is directed to an interior of the reactor body 11.

Hereinafter, a method to deeply etch the substrate 13 to be processed using a multi-inductively coupled plasma reactor 10 is described.

According to the invention, a specific portion of the substrate 13 to be processed is increasingly deepened by repeating etching the specific portion using the plasma reactor 10 described above, and depositing a passivation layer on the etched specific portion. That is, the specific portion of the substrate 13 to be processed is etched, and the passivation layer to protect the etched specific portion is deposited. Again, the specific portion is deeply etched by etching the substrate 13 to be processed after removing the passivation layer of a portion to be deeply etched in the etched specific portion.

The invention may be applied to an anisotropic etching of oxide. In a large meaning, the oxide refers to silicon, quartz, glass, heat-resistant glass, SiO₂ deposited by CVD, and SiO₂ deposited by heat, plasma or other means. The oxide may be doping processed or not. The etching is performed by radical generated by plasma. Especially, when etching the oxide, a method to etch the substrate anistotropically and reliably.

In the passivation depositing step, the passivation layer is deposited on a specific portion etched with polymer and all surface of the substrate to be processed.

The method to deeply etch the specific portion of the substrate 13 to be processed by repeatedly performing etching of the specific portion or depositing of the passivation layer is performed in the plasma reactor 10 in which any one of the steps has the central plasma source 20 and the peripheral plasma source 30. Here, both two steps may be performed by plasma in the plasma reactor 10. Further, even when the passivation layer is removed and etching is performed again in order to perform the repetition, it may be performed by plasma formed in the plasma reactor 10 according to the invention. At this time, the plasma does not etch the passivation layer self-actively. The plasma may include bulb gas or bulb mixture. Suitable plasma include inactive gases such as argon that physically removes polymers or gases that physically remove chemically increased base layer such as halo- or hydro-carbon. According to the invention, the etching and depositing steps described above are performed using one of gases such as C₄F₈, SF₆, O₂ and C₂H₄.

The steps of etching and depositing passivation layer described above are performed by the multi-inductively coupled plasma reactor 10 according to the invention. At this time, each step may be repeatedly performed in a reactor or repeatedly performed in separated plasma reactors. Here, when performing each step, process conditions suitable to the step to be performed are set in the plasma reactor. Further, by setting conditions to make a plurality of reactors suitable to the etching and depositing and by arranging each reactor in line type or in cluster type, the substrate to be processed may be processed while they moves from one substrate to be processed to another.

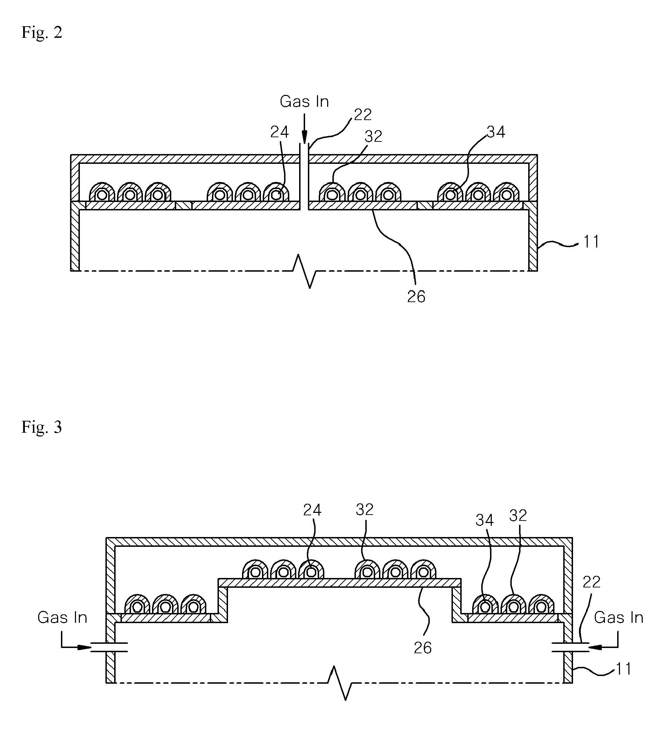

FIG.2 is an upper sectional view showing a plasma process apparatus that has no step between a central plasma source and a peripheral plasma source and has a gas inlet formed in the plasma source.

Referring to FIG. 2, the central plasma source 20 and the peripheral plasma source 30 may be installed on the reactor body 11 in the same height with respect to the substrate 13 to be processed. Process gas is provided into the reactor body 11 through the gas inlet 22 installed in the central plasma source 20 so that plasma is formed in the reactor body 11. At this time, the gas inlet 22 may be installed in the central plasma source 20 only or in both of the central plasma source 20 and the peripheral plasma source 30.

FIG.3 is an upper sectional view showing a plasma process apparatus that has a step between a central plasma source and a peripheral plasma source and has a gas inlet formed on a side wall of a reactor body.

Referring to FIG. 3, a gas inlet 22 is installed on a side wall of the reactor body 11. That is, the gas inlet 22 is installed in a vicinity of the peripheral plasma source 30. At this time, a gas inlet 22 may be further installed between the central plasma source 20 and the peripheral plasma source 30.

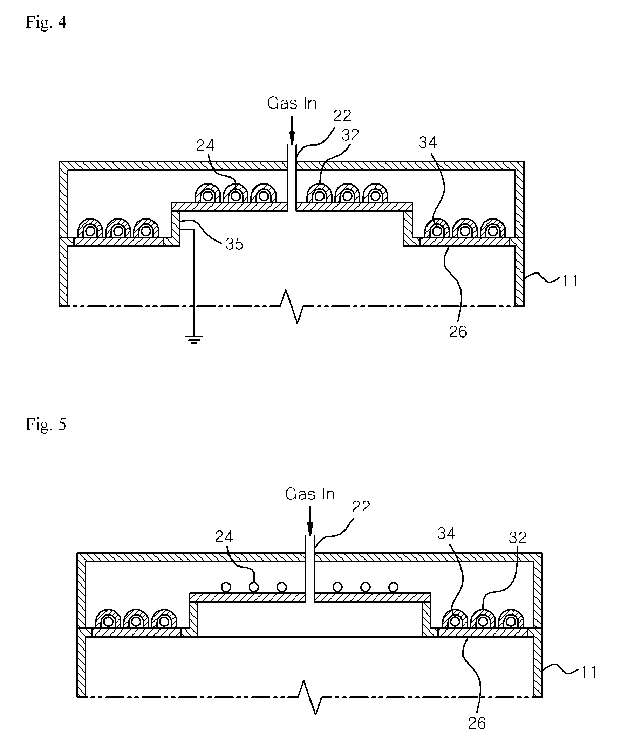

FIG.4 is an upper sectional view showing a plasma process apparatus having an interference prevention electrode that is grounded between a central plasma source and a peripheral plasma source.

Referring to FIG. 4, an interference prevention electrode 35 is installed between the central plasma source 20 and the peripheral plasma source 30. The interference prevention electrode 35 is grounded so that the central plasma source 20 and the peripheral plasma source 30 are electrically separated. That is, it is possible to independently control plasma formed in the central plasma source 20 and the peripheral plasma source 30 by the interference prevention electrode 35.

FIG.5 is an upper sectional view showing a plasma process apparatus that has a central plasma source formed of a planar shape.

Referring to FIG. 5, a magnetic core cover 32 may be installed in any one of the central plasma source 20 and the peripheral plasma source 30. According to the embodiment of the invention, the peripheral plasma source 20 includes a radio frequency antenna 34 and a magnetic core cover 322, and the central plasma source 20 includes a radio frequency antenna 24. It is to strengthen peripheral plasma formed by the peripheral plasma source 30. Here, the magnetic core cover 32 may be installed on both of the central plasma source 20 and the peripheral plasma source 30 or may not be installed on both of them.

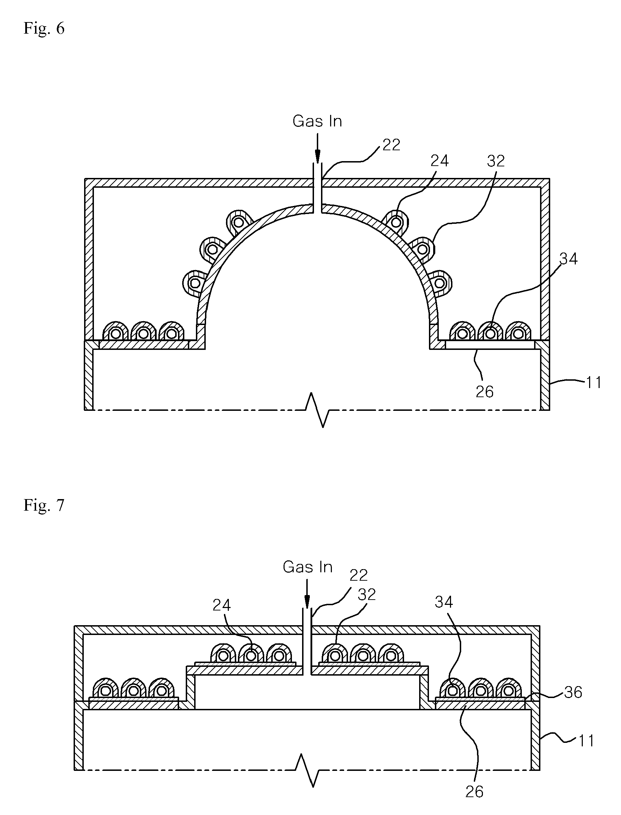

FIG.6 is an upper sectional view showing a plasma process apparatus that has a central plasma source formed of a dome shape.

Referring to FIG. 6, the plasma reactor 10 may have a central plasma source 20 that is formed of a core shape. While the plasma reactor 10 described above has the central plasma source 20 that is formed in parallel to the peripheral plasma source 30, the central plasma source 20 may be formed of a dome shape.

FIG.7 is an upper sectional view showing a plasma process apparatus that has a Faraday shield.

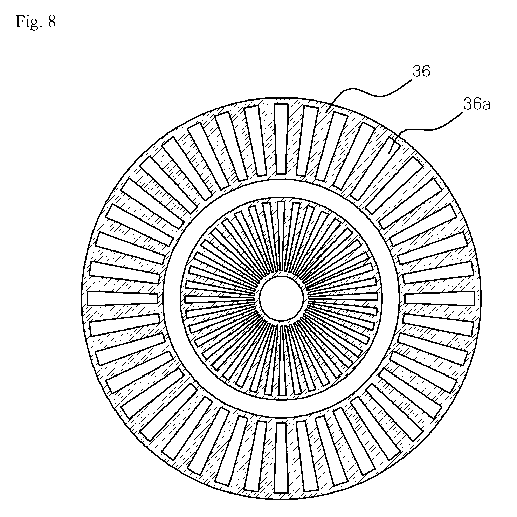

Referring to FIG. 7, in a case, a Faraday shield 36 may be installed between a dielectric window 26 and radio frequency antennas 24 and 34. The Faraday shield 36 is constructed of the same shape as the dielectric window 26, and a plurality of magnetic flux transfer holes 36a are formed on a plate surface, as shown in FIG. 8. The Faraday shield 36 is installed in each of the central plasma source 20 and the peripheral plasma source 30. Here, a magnetic flux transfer ratio in which magnetic flux of the magnetic core 32 is transferred to the reactor body 11 is controlled according to an area taken by the magnetic flux transfer holes 36a in the Faraday shield 36.

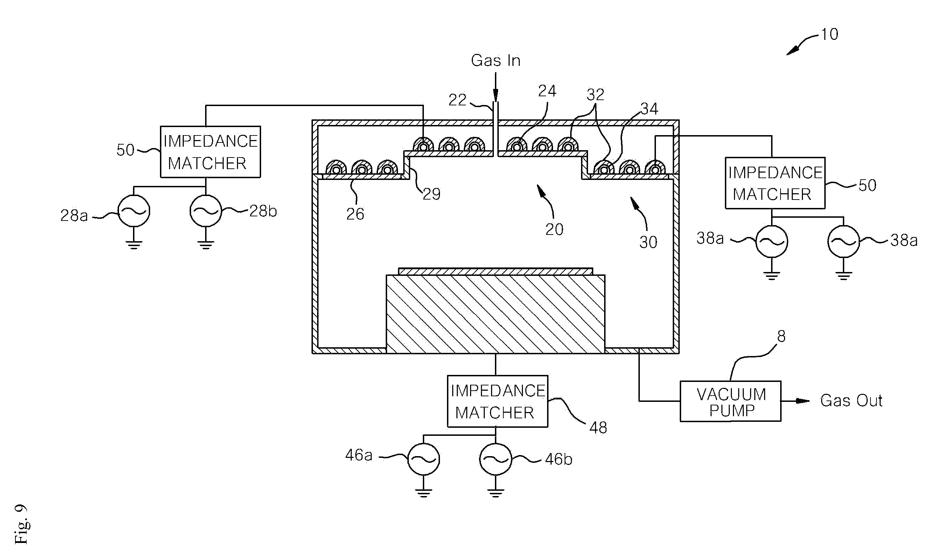

FIG.9 is a sectional view showing a plasma process apparatus that an double central power supply and a double peripheral power supply and a double bias power supply.

Referring to FIG. 9, radio frequency antennas 24 and 34 of the central plasma source 20 and the peripheral plasma source 30 are connected to two power supplies, respectively. The central plasma source 20 is connected to two central power supplies 28a and 28b, and the peripheral plasma source 30 is connected to two peripheral power supplies 38a and 38b. At this time, respective power supplies provide the radio frequency antennas 24 and 34 with radio frequencies different each other. Therefore, it is possible to control plasma generated by the central plasma source 20 and the peripheral plasma source 30 using each power supply.

Further, double bias structure may be formed by connecting two bias power supplies 46a and 46b to the substrate support 12. The double bias structure of the substrate support 12 easily generates plasma in the plasma rector 10, and further improves plasma ion energy control so that process productivity may be enhanced.

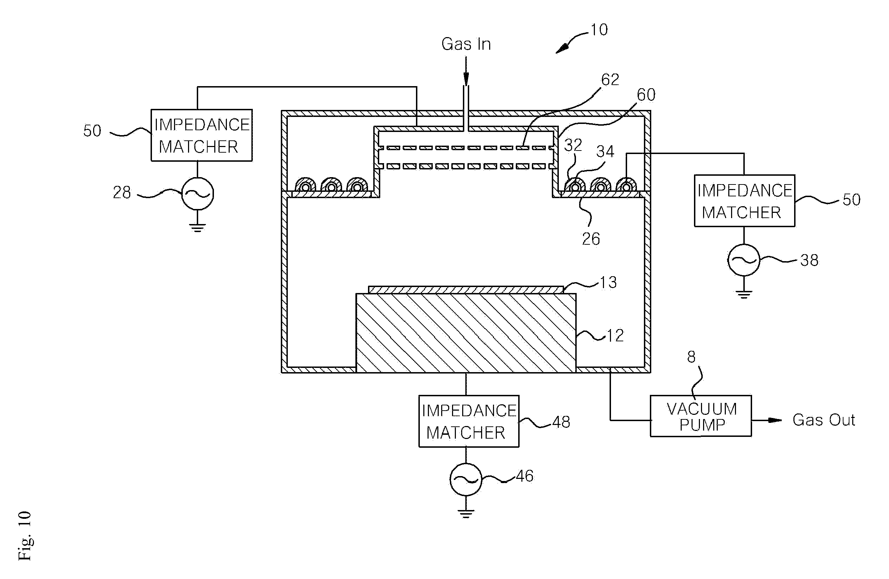

FIG.10 is a sectional view showing a plasma process apparatus that has a central plasma source formed of capacitive coupled plasma.

Referring to FIG. 10, in the plasma reactor 10, the central plasma source 20 includes a gas supplier 60 of a shower head shape and an electrode (not shown). The central plasma source 20 includes a gas supplier 60 having a baffle 62 and an electrode formed under the gas supplier 60 so that it forms plasma. At this time, the peripheral plasma source 30 forms plasma using a radio frequency as described above.

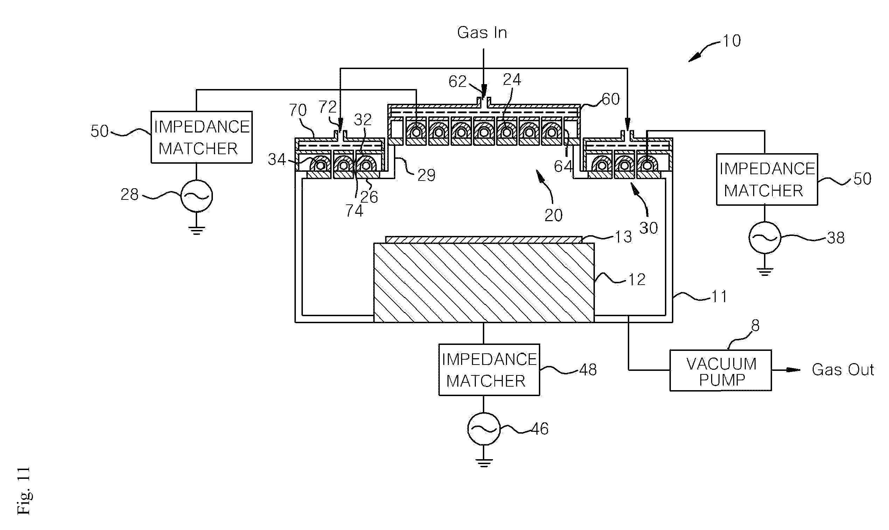

FIG.11 is a sectional view showing a plasma process apparatus that has a multiple gas supply structure according to a preferred embodiment of the invention.

Referring to FIG. 11, the central plasma source 20 and the peripheral plasma source 30 of the preferred plasma reactor 10 of the invention include gas supplier and radio frequency antennas 24 and 34 and the dielectric window 26. The gas supplier is constructed of a central gas supplier 65 included in the central plasma source 20 and a peripheral gas supplier 70 included in the peripheral plasma source 30. The central gas supplier 65 and the peripheral gas supplier 70 have a gas inlets 67 and 72 and a plurality of gas nozzles 69 and 74, respectively. The central gas supplier 65 and the peripheral gas supplier 70 provide the same process gas into the reactor body 11. The central gas supplier 65 and the peripheral gas supplier 70 have the central radio frequency antenna 24 and the peripheral radio frequency antenna 34 installed in their lower portions, and the central radio frequency antenna 24 and the peripheral radio frequency antenna 34 have dielectric windows in their lower portions.

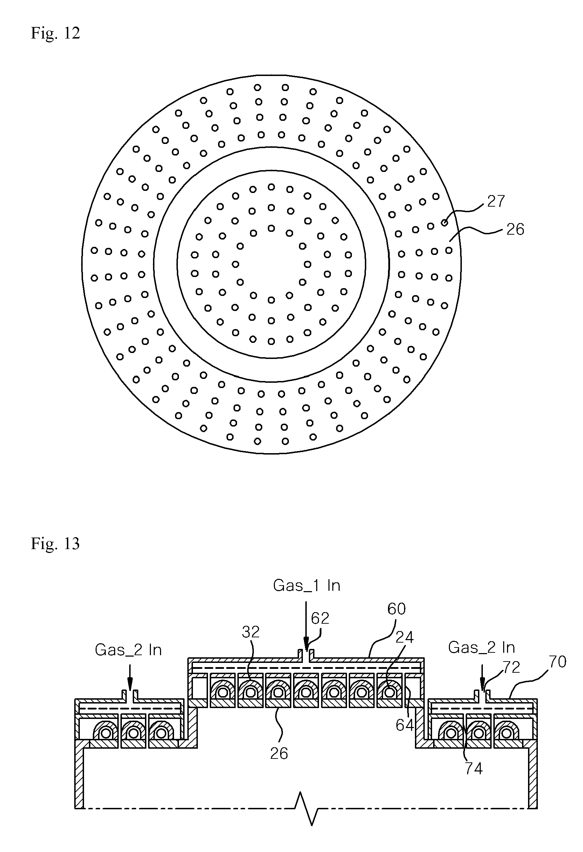

FIG.12 is a plane view showing a dielectric window having a plurality of gas supply holes that are installed in a plasma process apparatus of the invention.

Referring to FIG. 12, the dielectric window 26 is generally formed of a circular shape, and a plurality of gas supply holes 27 are formed in it. A dielectric window 26 enables magnetic flux generated from the radio frequency antenna to pass through the reactor body 11. The dielectric window 26 has a plurality of gas supply holes 27 installed correspondingly to gas nozzles 69 and 74 of the gas suppliers 65 and 70.

Further, as shown in FIG. 11, magnetic core cover 32 is installed on the central radio frequency antenna 24 and the peripheral radio frequency antenna 34 so as to make magnetic flux directed to the inner part of the reactor body 11. The magnetic core cover 32 may be installed in any one of the central plasma source 20 and the peripheral plasma source 30, or may be installed in both of the central plasma source 20 and the peripheral plasma source 30.

The central plasma source 20 and the peripheral plasma source 30 may be installed in the reactor body 11 with different heights with respect to the substrate 13 to be processed. That is, the central plasma source 20 is highly formed on the substrate 13 to be processed compared with the peripheral plasma source 30 so that plasma is prevented from being concentrated on the central area only. Therefore, plasma is formed uniformly and process efficiency with respect to the substrate 13 to be processed is enhanced. By doing so, plasma is processed on the entire area of the substrate in consideration of intensity and strength of central plasma and peripheral plasma. The central plasma source can be formed in the same height as the peripheral plasma source.

FIG.13 is a sectional view showing a plasma process apparatus in which a central gas supplier and a peripheral gas supplier are provided with different process gases, respectively, according to a preferred embodiment of the invention

Referring to FIG. 13, the plasma reactor 10 can provide different process gases into the reactor body 11 through the central plasma source 20 and the peripheral plasma source 30. A first gas provided from a gas supplier (not shown) is provided into the central plasma source 20 through the central gas supplier 65 and a second gas is provided into the peripheral plasma source 30 through the peripheral gas supplier 70.

As described above, the multi-inductively coupled plasma reactor and method thereof according to the embodiment of the invention is an example, and it will be obvious that the same may be varied in many ways. Such variations are not to be regarded as a departure from the spirit and scope of the invention, and all such modifications as would be obvious to one skilled in the art are intended to be included within the scope of the following claims.

## Claims

1. In a multi-inductively coupled plasma reacting method, an etching method to increase a specific portion of a substrate to be processed, comprises:
etching a specific portion of a substrate to be processed; and
depositing a passivation layer on a surface of the specific portion etched,
wherein the etching and depositing steps are repeatedly proceeded, and one of both steps is executed when there is plasma formed by a central plasma source and a peripheral plasma source.

2. The multi-inductively coupled plasma reacting method according to claim 1, wherein both steps of etching and depositing are executed when there is plasma formed by the central plasma source and the peripheral plasma source.

3. The multi-inductively coupled plasma reacting method according to claim 1 or 2, wherein the passivation layer of the specific portion is removed and etched again when there is plasma formed by the central plasma source and the peripheral plasma source.

4. The multi-inductively coupled plasma reacting method according to claim 2, wherein the central plasma source and the peripheral plasma source each generate plasma using an inductive coupling method.

5. The multi-inductively coupled plasma reacting method according to claim 2, wherein the central plasma source generates plasma using a capacitive coupling method and the peripheral plasma source generates plasma using an inductive coupling method.

6. A multi-inductively coupled plasma reactor, comprising:
a reactor body that internally includes a substrate support to support a substrate to be processed;
a central plasma source that generates plasma in a central area of the reactor body; and
a peripheral plasma source that generates plasma in a peripheral area of the reactor body,
wherein an etching and a deposition of a passivation layer with respect to a specific portion of the substrate to be processed are repeatedly performed.

7. The multi-inductively coupled plasma reactor according to Claim 6, wherein the central plasma source and the peripheral plasma source each generate plasma using an inductive coupling method.

8. The multi-inductively coupled plasma reactor according to Claim 6, wherein the central plasma source generates plasma using a capacitive coupling method and the peripheral plasma source generates plasma using an inductive coupling method.

9. The multi-inductively coupled plasma reactor according to any of Claims 6 to 8, wherein the central plasma source and the peripheral plasma source are arranged differently from the substrate to be processed in their heights.

10. The multi-inductively coupled plasma reactor according to any of Claims 6 to 9, wherein the central plasma source is one of a planar form and a dome form.

11. The multi-inductively coupled plasma reactor according to any of Claims 6 to 10, further comprising a central power supply to provide the central plasma source with power and a peripheral power supply to provide the peripheral plasma source with power; and optionally wherein the central power supply and the peripheral power supply provide power source of different frequencies, respectively.

12. The multi-inductively coupled plasma reactor according to Claim 11, wherein the central power supply source provides power having frequency of 1∼5MHz, and the peripheral power supply source having frequency of 1 -500KHz.

13. The multi-inductively coupled plasma reactor according to any of Claims 6 to 12, wherein the substrate support is connected to a bias supply source that provides a bias power source of 1∼50MHz.

14. The multi-inductively coupled plasma reactor according to any of Claims 6 to 13, wherein the central plasma source or the peripheral plasma source includes: a radio frequency antenna; and
a magnetic core cover that covers the radio frequency antenna and is arranged such that an entrance of magnetic flux is directed to an interior of the reactor body
and optionally wherein the radio frequency antenna further includes a Faraday shield in its lower portion.

15. The multi-inductively coupled plasma reactor according to any of Claims 6 to 15, wherein an interference prevention electrode is arranged between the central plasma source and the peripheral plasma source and grounded so as to electrically separate the central plasma source and the peripheral plasma source each other.

16. The multi-inductively coupled plasma reactor according to any of Claims 6 to 15, wherein the central plasma source includes a central gas supplier and the peripheral plasma source includes a peripheral gas supplier, such that a process gas is supplied;
and optionally wherein the central gas supplier and the peripheral gas supplier include a plurality of gas nozzles;
and optionally wherein the central gas supplier and the peripheral gas supplier provide the same process gas or different process gas from the gas supply source.
